# EUROPEAN PATENT SPECIFICATION

(11) **EP 1 928 017 B1**
(45) Date of publication and mention of the grant of the patent: **12.05.2010**
(21) Application number: 07021043.0
(22) Date of filing: 26.10.2007
(51) Int. Cl.: H01L 21/68, H01L 21/00, H01J 37/32

(54) **Plasma reactor substrate mounting surface texturing**
Oberflächenstrukturierung von einer Substrathalterung in einem Plasmareaktor
Texturation d'une surface de montage de substrat de réacteur à plasma

(30) Priority: 01.12.2006 US 566113
(43) Date of publication of application: 04.06.2008
(73) Proprietor: Applied Materials, Inc., Santa Clara, CA 95054 (US)
(72) Inventor: White, John M., Hayward, CA 94541 (US); Ye, Zhifei, Fremont, CA 94539 (US)
(74) Representative: Zimmermann, Gerd Heinrich

(56) References cited:
- JP-A- 2001 007 087
- JP-A- 2005 018 992
- KR-A- 2004 036 984
- US-A- 5 096 536
- US-A- 2005 191 830

## Description

### BACKGROUND OF THE INVENTION

### Field of the Invention

The present invention generally relates to an apparatus and method for processing large area substrates. More particularly, the present invention relates to a substrate support for supporting large area substrates in semiconductor processing and a method of fabricating the same.

### Description of the Related Art

Equipment for processing large area substrates has become a substantial investment in manufacturing of flat panel displays including liquid crystal displays (LCDs) and plasma display panels (PDPs), organic light emitting diodes (OLEDs), and solar panels. A large area substrate for manufacturing LCD, PDP, OLED or solar panels may be a glass or a polymer workpiece.

The large area substrate is typically subjected to a plurality of sequential processes to created devices, conductors, and insulators thereon. Each of these processes is generally performed in a process chamber configured to perform a single step of the production process. In order to efficiently complete the entire sequential processes, a number of process chambers are typically used. One fabrication process frequently used to process a large area substrate is plasma enhanced chemical vapor deposition (PECVD).

PECVD is generally employed to deposit thin films on a substrate such as a flat panel substrate or a semiconductor substrate. PECVD is typically performed in a vacuum chamber between parallel electrodes positioned several inches apart, typically with a variable gap for process optimization. A substrate being processed may be disposed on a temperature controlled substrate support disposed in the vacuum chamber. In some cases, the substrate support may be one of the electrodes. A precursor gas is introduced into the vacuum chamber and is typically directed through a distribution plate situated near the top of the vacuum chamber. The precursor gas in the vacuum chamber is then energized or excited into a plasma by applying a RF power coupled to the electrodes. The excited gas reacts to form a layer of material on a surface of the substrate positioned on the substrate support. Typically, a substrate support or a substrate support assembly in a PECVD chamber is configured to support and heat the substrate as well as serve as an electrode to excite the precursor gas.

Generally, large area substrates, for example those utilized for flat panel fabrication, are often exceeding 550mm x 650mm, and are envisioned up to and beyond 4 square meters in surface area. Correspondingly, the substrate supports utilized to process large area substrates are proportionately large to accommodate the large surface area of the substrate. The substrate supports for high temperature use typically are casted, encapsulating one or more heating elements and thermocouples in an aluminum body. Due to the size of the substrate support, one or more reinforcing members are generally disposed within the substrate support to improve the substrate support's stiffness and performance at elevated operating temperatures (*i*.*e*., in excess of 350 degrees Celsius and approaching 500 degrees Celsius to minimize hydrogen content in some films). The aluminum substrate support is then anodized to provide a protective coating.

Although substrate supports configured in this manner have demonstrated good processing performance, two problems have been observed. The first problem is non-uniform deposition. Small local variations in film thickness, often manifesting as spots of thinner film thickness, have been observed which may be detrimental to the next generation of devices formed on large area substrates. It is believed that variation in substrate thickness and flatness, along with a smooth substrate support surface, typically about 1,27 × 10⁻⁶ m (50 micro-inches), creates a local capacitance variation in certain locations across the glass substrate, thereby creating local plasma nonuniformities that results on deposition variation, e.g., spots of thin deposited film thickness.

The second problem is caused by the static charge generated by the triboelectric process, or the process of bringing two materials into contact with each other and then separating them from each other. As a result, electrostatics may build up between the substrate and the substrate support making it difficult to separate the substrate from the substrate support once the process is completed.

An additional problem is known in the industry as the electro-static discharge (ESD) metal lines arcing problem. As the substrate size increased, the ESD metal lines become longer and larger. It is believed that the inductive current in the ESD metal lines becomes large enough during plasma deposition to damage the substrate. This ESD metal lines arcing problem has become a major recurring problem.

Therefore, there is a need for a substrate support that provides necessary capacitive decoupling of a substrate being processed from the substrate support and sufficient coupling to provide good film deposition performance.
JP 2001 007087 A discloses a single-wafer processing plasma ashing apparatus, wherein protrusions point-contacted to a central part of a wafer and arcuate protrusions line-contacted to the periphery of the wafer are provided on a stage.
In JP 2005 018992 A an electrode embedding member for a plasma generator is described, the electrode embedding member being composed by installing at least a plasma generating electrode in the ceramic substrate.
US 5,096,536 is directed to an apparatus for cooling selected substrates treated in plasma etching systems having a substrate-supporting electrode disposed within a plasma reaction chamber and operative to receive a selected substrate above one surface thereof, said apparatus including a first closed seal at one radial distance from a central point on said electrode and between said substrate and said electrode and a second closed seal at a second and greater radial distance from said central point on said electrode.
KR 2004 0036984 A mentions a chamber including a lower electrode which has an insulating spray layer and a circumferential concave part to which an arc preventing agent is applied.
US 2005/0191830 A1 discloses a chuck in a plasma reactor for securing a wafer, the chuck having an electrode made of a wire mesh or metal layer inside an insulating puck.

### SUMMARY OF THE INVENTION

The aforementioned problems are at least partly solved by a substrate support for using in a plasma reactor as laid out in claim 1, and a method as laid out in claim 11.

Further aspects, details, features and embodiments are evident from the dependent claims, the description and the accompanying drawings.

The present invention generally provides apparatus and methods for providing necessary capacitive decoupling to a large area substrate in a plasma reactor.

A substrate support for using in a plasma reactor, including an electrically conductive body configured to be an electrode of the plasma reactor, wherein the electrically conductive body has a top surface configured for supporting a large area substrate and providing heat energy to the large area substrate, the top surface has a plurality of raised areas and a plurality of lowered areas, the plurality of raised areas are configured for contacting a back surface of the large area substrate, the plurality of raised areas occupy less than 50% of the surface area of the top surface, and the plurality of raised areas are evenly distributed across the top surface.

A method for processing a large area substrate in a plasma chamber, including providing a substrate support having an electrically conductive body, wherein the electrically conductive body has a top surface configured for supporting a large area substrate and providing heat energy to the large area substrate, the top surface has a plurality of raised areas and a plurality of lowered areas, the plurality of raised areas are configured for contacting a back surface of the large area substrate, and the plurality of raised areas occupy less than 50% of the surface area of the top surface and are evenly distributed across the top surface; positioning the large area substrate on the top surface of the substrate support; introducing a precursor gas to the plasma chamber; and generating a plasma of the precursor gas by applying an RF power between the electrically conductive body and an electrode parallel to the electrically conductive body.

### BRIEF DESCRIPTION OF THE DRAWINGS

So that the manner in which the above recited features of the present invention can be understood in detail, a more particular description of the invention, briefly summarized above, may be had by reference to embodiments, some of which are illustrated in the appended drawings. It is to be noted, however, that the appended drawings illustrate only typical embodiments of this invention and are therefore not to be considered limiting of its scope, for the invention may admit to other equally effective embodiments.

Figure 1 schematically illustrates a cross sectional view of a plasma enhanced chemical vapor deposition chamber in accordance with one embodiment of the present invention.

Figure 2 schematically illustrates a partial perspective view of a substrate support in a plasma enhanced chemical vapor deposition chamber.

Figure 3 is a schematic enlarged view of an interface between a substrate and a top surface of a substrate support in accordance with one embodiment of the present invention.

Figure 4 schematically illustrates one embodiment of a top surface of a substrate support in accordance with one embodiment of the present invention.

Figures 5A-D schematically illustrate a sequential process for making a top surface of a substrate support of the present invention.

Figures 6A-B schematically illustrate another process for making a top surface of a substrate support of the present invention.

To facilitate understanding, identical reference numerals have been used, where possible, to designate identical elements that are common to the figures. It is to be noted, however, that the appended drawings illustrate only typical embodiments of this invention and are therefore not to be considered limiting of its scope, for the invention may admit to other equally effective embodiments.

### DETAILED DESCRIPTION

The present invention relates to a substrate support that provides necessary capacitive decoupling to a substrate being processed and methods of making the substrate support. Particularly, the substrate support of the present invention reduces the electrostatics between the substrate and the substrate support and to minimize plasmoid which usually appears with damaged substrates. Although not wishing to be bound by theory, it is believed that intensive plasma over metal lines on a large area substrate heats the large area substrate unevenly causing thermal stress in the large area substrate. The thermal stress in the large area substrate may build up large enough to fracture the large area substrate. Once the nonconductive large area substrate is broken, the conductive substrate support is exposed to the plasma, arcing, or plamoid, occurs. The substrate support of the present invention reduces electrostatics, minimizes plasmoid, as well as provides good film deposition performance.

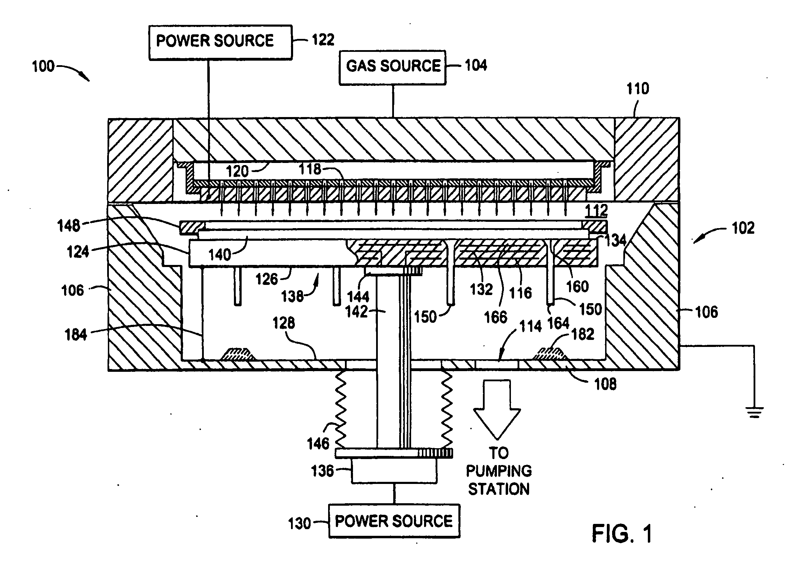

Figure 1 schematically illustrates a cross sectional view of a plasma enhanced chemical vapor deposition system 100 in accordance with one embodiment of the present invention. The plasma enhanced chemical vapor deposition system 100 is configured to form structures and devices on a large area substrate, for example, a large area substrate for use in the fabrication of liquid crystal displays (LCDs), plasma display panels (PDPs), organic light emitting diodes (OLEDs), and solar panels. The large area substrate being processed may be a glass substrate or a polymer substrate.

The system 100 generally includes a chamber 102 coupled to a gas source 104. The chamber 102 comprises chamber walls 106, a chamber bottom 108 and a lid assembly 110 that define a process volume 112. The process volume 112 is typically accessed through a port (not shown) formed in the chamber walls 106 that facilitates passage of a large area substrate 140 (hereafter substrate 140) into and out of the chamber 102. The substrate 140 may be a glass or polymer workpiece. In one embodiment, the substrate 140 has a plan surface area greater than about 0.25 meters. The chamber walls 106 and chamber bottom 108 are typically fabricated from a unitary block of aluminum or other material compatible for plasma processing. The chamber walls 106 and chamber bottom 108 are typically electrically grounded. The chamber bottom 108 has an exhaust port 114 that is coupled to various pumping components (not shown) to facilitate control of pressure within the process volume 112 and exhaust gases and byproducts during processing.

In the embodiment depicted in Figure 1, the chamber body 102 has a gas source 104, and a power source 122 coupled thereto. The power source 122 is coupled to a gas distribution plate 118 to provide an electrical bias that energizes the process gas and sustains a plasma formed from process gas in the process volume 112 below the gas distribution plate 118 during processing.

The lid assembly 110 is supported by the chamber walls 106 and can be removed to service the chamber 102. The lid assembly 110 is generally comprised of aluminum. The gas distribution plate 118 is coupled to an interior side 120 of the lid assembly 110. The gas distribution plate 118 is typically fabricated from aluminum. The center section of the gas distribution plate 118 includes a perforated area through which process gases and other gases supplied from the gas source 104 are delivered to the process volume 112. The perforated area of the gas distribution plate 118 is configured to provide uniform distribution of gases passing through the gas distribution plate 118 into the chamber 102. Detailed description of the gas distribution plate 118 may be found in United States Patent Application Publication US 2006228496, entitled, "Plasma Uniformity Control by Gas Diffuser Curvature" and United States Patent Application Publication US 2009007846 "Diffuser Gravity Support".

A substrate support assembly 138 is centrally disposed within the chamber 102. The substrate support assembly 138 is configured to support the substrate 140 during processing. The substrate support assembly 138 generally comprises an electrically conductive body 124 supported by a shaft 142 that extends through the chamber bottom 108.

The support assembly 138 is generally grounded such that RF power supplied by the power source 122 to the gas distribution plate 118 (or other electrode positioned within or near the lid assembly of the chamber) may excite the gases disposed in the process volume 112 between the support assembly 138 and the gas distribution plate 118. The RF power from the power source 122 is generally selected commensurate with the size of the substrate to drive the chemical vapor deposition process. In one embodiment, the conductive body 124 is grounded through one or more RF ground return path members 184 coupled between a perimeter of the conductive body 124 and the grounded chamber bottom 108. Detailed description of RF ground return path members 184 may be found in United States Patent Application Publication US 2006034032, entitled "Method and Apparatus for Dechucking a Substrate".

in one embodiment, at least the portion of the conductive body 124 may be covered with an electrically insulative coating to improve deposition uniformity without expensive aging or plasma treatment of the support assembly 138. The conductive body 124 may be fabricated from metals or other comparably electrically conductive materials. The coating may be a dielectric material such as oxides, silicon nitride, silicon dioxide, aluminum dioxide, tantalum pentoxide, silicon carbide, polyimide, among others, which may be applied by various deposition or coating processes, including but not limited to, flame spraying, plasma spraying, high energy coating, chemical vapor deposition, spraying, adhesive film, sputtering and encapsulating. Detailed description of the coating may be found in United States Patent Application Publication US 2004221959, entitled "Anodized Substrate Support"), and United States Patent Application Publication US 2006032586, entitled "Reduced Electrostatic Charge by Roughening the Susceptor".

In one embodiment, the conductive body 124 encapsulates at least one embedded heating element 132. At least a first reinforcing member 116 is generally embedded in the conductive body 124 proximate the heating element 132. A second reinforcing member 166 may be disposed within the conductive body 124 on the side of the heating element 132 opposite the first reinforcing member 116. The reinforcing members 116 and 166 may be comprised of metal, ceramic or other stiffening materials. In one embodiment, the reinforcing members 116 and 166 are comprised of aluminum oxide fibers. Alternatively, the reinforcing members 116 and 166 may be comprised of aluminum oxide fibers combined with aluminum oxide particles, silicon carbide fibers, silicon oxide fibers or similar materials. The reinforcing members 116 and 166 may include loose material or may be a prefabricated shape such as a plate. Alternatively, the reinforcing members 116 and 166 may comprise other shapes and geometry. Generally, the reinforcing members 116 and 166 have some porosity that allows aluminum to impregnate the members 116, 166 during a casting process described below.

The heating element 132, such as an electrode disposed in the support assembly 138, is coupled to a power source 130 and controllably heats the support assembly 138 and the substrate 140 positioned thereon to a desired temperature. Typically, the heating element 132 maintains the substrate 140 at a uniform temperature of about 150 to at least about 460 degrees Celsius. The heating element 132 is generally electrically insulated from the conductive body 124.

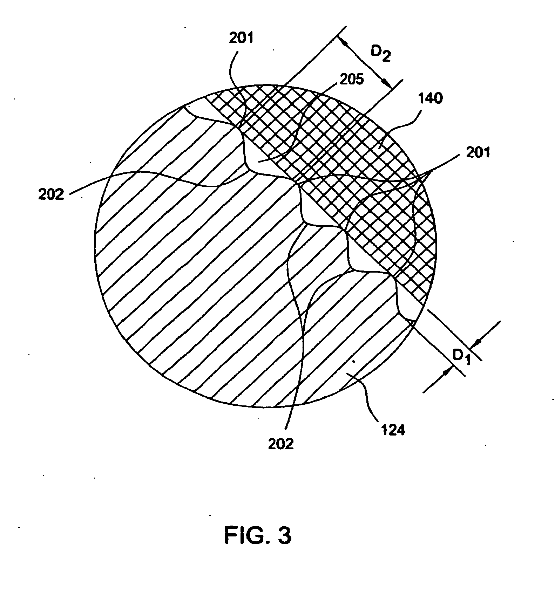

The conductive body 124 has a lower side 126 and a top surface 134 configured to support the substrate 140 and provide heat energy to the substrate 140. The top surface 134 may be roughened so that space pockets 205 (as shown in Figure 3) may be formed between the top surface 134 and the substrate 140. The space pockets 205 reduce capacitive coupling between the conductive body 124 and the substrate 140. In one embodiment, the top surface 134 may be a non-planar surface configured to be partially in contact with the substrate 140 during process.

The lower side 126 has a stem cover 144 coupled thereto. The stem cover 144 generally is an aluminum ring coupled to the support assembly 138 that provides a mounting surface for the attachment of the shaft 142 thereto.

The shaft 142 extends from the stem cover 144 and couples the support assembly 138 to a lift system (not shown) that moves the support assembly 138 between an elevated position (as shown) and a lowered position. A bellows 146 provides a vacuum seal between the process volume 112 and the atmosphere outside the chamber 102 while facilitating the movement of the support assembly 138.

The support assembly 138 additionally supports a circumscribing shadow frame 148. Generally, the shadow frame 148 prevents deposition at the edge of the substrate 140 and support assembly 138 so that the substrate does not stick to the support assembly 138.

The support assembly 138 has a plurality of holes 128 formed therethrough that accept a plurality of lift pins 150. The lift pins 150 are typically comprised of ceramic or anodized aluminum. Generally, the lift pins 150 have first ends 160 that are substantially flush with or slightly recessed from a top surface 134 of the support assembly 138 when the lift pins 150 are in a normal position (*i*.*e*., retracted relative to the support assembly 138). The first ends 160 are generally flared or otherwise enlarged to prevent the lift pins 150 from falling through the holes 128. Additionally, the lift pins 150 have a second end 164 that extends beyond the lower side 126 of the support assembly 138. The lift pins 150 come in contact with the chamber bottom 108 and are displaced from the top surface 134 of the support assembly 138, thereby placing the substrate 140 in a spaced-apart relation to the support assembly 138.

In one embodiment, lift pins 150 of varying lengths are utilized so that they come into contact with the bottom 108 and are actuated at different times. For example, the lift pins 150 that are spaced around the outer edges of the substrate 140, combined with relatively shorter lift pins 150 spaced inwardly from the outer edges toward the center of the substrate 140, allow the substrate 140 to be first lifted from its outer edges relative to its center. In another embodiment, lift pins 150 of a uniform length may be utilized in cooperation with bumps or plateaus 182 positioned beneath the outer lift pins 150, so that the outer lift pins 150 are actuated before and displace the substrate 140 a greater distance from the top surface 134 than the inner lift pins 150. Alternatively, the chamber bottom 108 may comprise grooves or trenches positioned beneath the inner lift pins 150, so that the inner lift pins 150 are actuated after and displaced a shorter distance than the outer lift pins 150. Embodiments of a system having lift pins configured to lift a substrate in an edge to center manner from a substrate support that may be adapted to benefit from the invention are described in United States Patent No. 6,676,761.

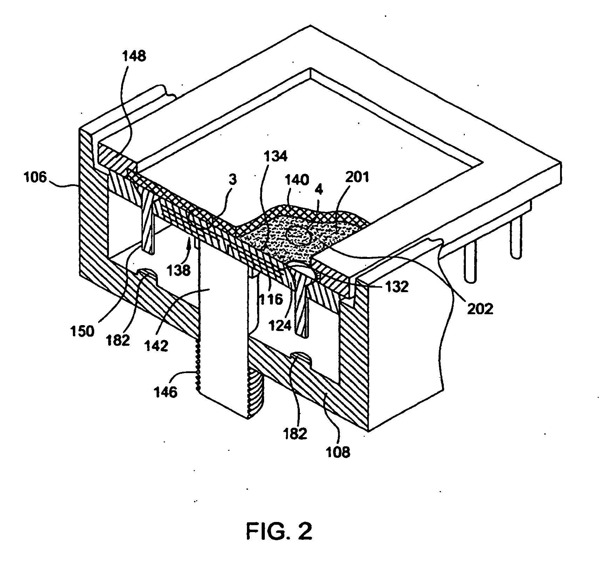

Figure 2 schematically illustrates a partial perspective view of the substrate support assembly 138 in the plasma enhanced chemical vapor deposition system 100. The conductive body 124 of the substrate support assembly 138 has a textured top surface 134. In one embodiment, the top surface 134 comprises a plurality of raised areas 201 configured to contact the substrate 140 supported thereon and a plurality of lowered areas 202. In one embodiment, the raised areas 201 and neighboring lowered areas 202 are connected in a substantially continuous manner (further described with Figure 3) to prevent the textured top surface 134 from scratching the substrate 140. The substrate 140 positioned on the conductive body 124 is separated from the lowered areas 202 by the raised areas 201. The raised areas 201 only occupy a limited percentage of the entire top surface 134 to provide the substrate 140 enough capacitive decoupling from the conductive body 124, therefore, avoid metal line arcing and undesired electrostatics. In one embodiment, the raised areas 201 occupy less than about 50% of the entire top surface 134.

Figure 3 is a schematic enlarged view of an interface between the substrate 140 and the top surface 134 of the conductive body 124. Areas near the raised areas 201 are relatively smooth so that the substrate 140 is not scratched by the top surface 134. In one embodiment, the top surface 134 is a substantially continuous wherein the lowered areas 202 are smoothly connected to neighboring raised areas 201. In one embodiment, the distance D1 between the lowest point of the lowered areas 202 and the highest point of the raised areas 201 is between about 0.0254mm (0.001 inch) to about 0.0508mm (0.002 inch). The distance between neighboring raised areas 201 is between about 0.5mm to about 3mm. Preferably, the distance between neighboring raised areas 201 is between about 1 mm to about 2mm.

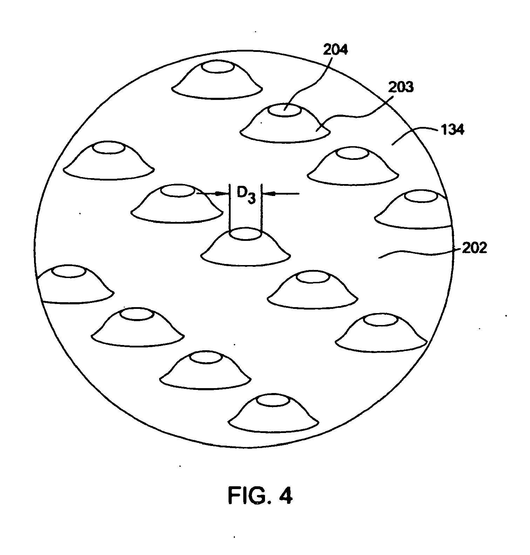

The raised areas 201 may be evenly distributed across the top surface 134. In one embodiment, the raised areas 201 may be an array of islands formed on the top surface 134. In one embodiment, the raised areas 201 may be a plurality of islands in closed packed hexagonal arrangement, as shown in Figure 4. Referring to figure 4, one embodiment of the top surface 134 of the conductive body 124 may have an array of rounded islands 203 formed thereon. Each of the islands 203 may have a flat area 204 configured to be a contact area for a substrate. In one embodiment, the flat area 204 may have a diameter of less than 0.5mm. Each of the islands 203 may have a smooth surface to avoid scratching of the substrate.

It should be noted that other suitable patterns that provide a smooth contact surface and enough capacitive decoupling may be applied to the top surface 134.

The top surface 134 of the conductive body 124 may be fabricated in various ways, such as for example, chemical etching, electropolishing, texturing, grinding, abrasive blasting, and knurling.

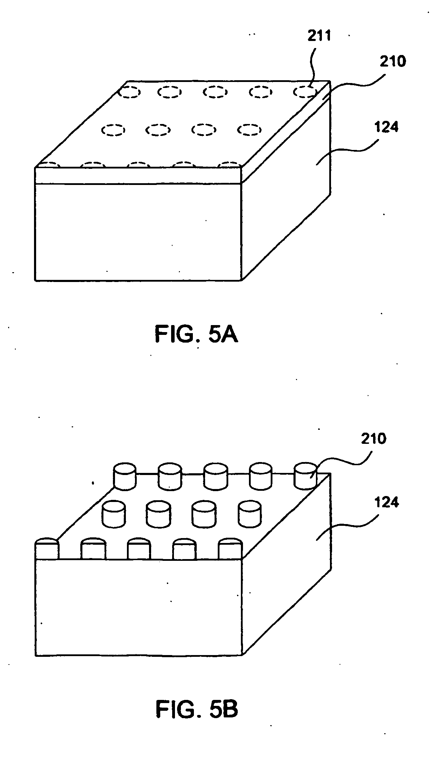

Figures 5A-D schematically illustrate a sequential process for making the top surface 134 of the conductive body 124 in the substrate support assembly 138 by chemical etching.

Figure 5A illustrates that a layer of photoresist 210 is coated on the conductive body 124. A pattern 211 is then formed in the photoresist 210 by exposing the photoresist 210 to a UV light through a mask.

Figure 5B illustrates the conductive body 124 with the photoresist 210 after the photoresist 210 has been developed.

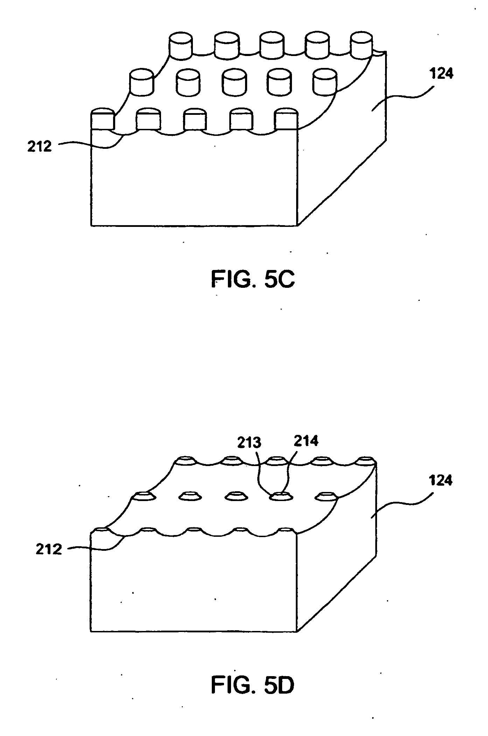

The conductive body 124 with a patterned photoresist 210 is then dipped into a chemical etching solution to form a plurality of lowered areas 212 on exposed part of the conductive body 124, as shown in Figure 5C.

Figure 5D illustrates the conductive body 124 after the photoresist 210 has been removed. A plurality of islands 213 remain protruding from the plurality of lowered areas 212. In one embodiment, each island 213 may have a contact area 214 which is part of the original top surface of the conductive body 124 untouched by the etching solution. The contact area 214 is configured to be in contact with a substrate during process. Since the contact area 214 on each island 213 may preserve characteristics of the original top surface of the conductive body 124, such as flatness and roughness, the substrate may be evenly supported by each contact areas 214 in the same manner as it would by an unetched top surface of the conductive body 124.

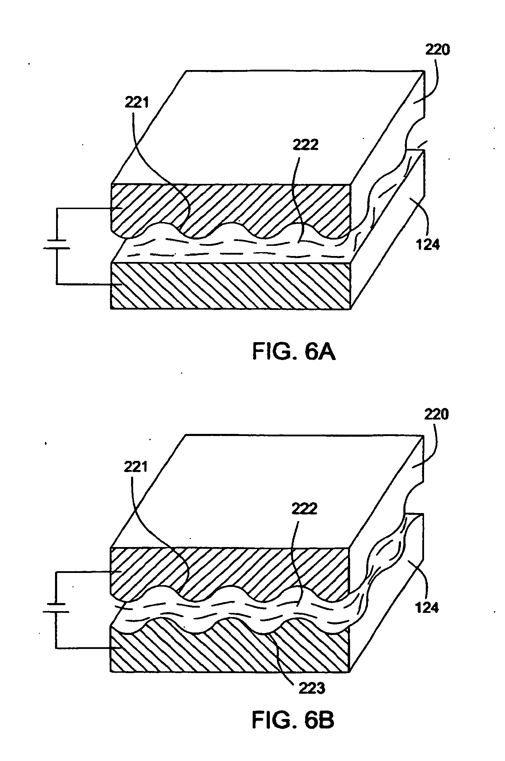

Figures 6A-B schematically illustrate an electropolishing method for manufacturing the top surface 134 of the conductive body 124 in the substrate support assembly 138 by electropolishing. A cathode 220 is positioned adjacent the conductive body 124 in a parallel manner in an electropolishing bath 222. The cathode 220 has a cathode pattern formed on a patterned surface 221. A power source 224 is applied between the conductive body 124 and the cathode 220 to provide electrical power to an electropolishing reaction. Figure 6B illustrates that a complementary pattern 223 of the cathode pattern 221 has been formed on the conductive body 124 because electric field has a higher concentration at protruding surfaces than at concaving surfaces in an electrochemical reaction.

In one embodiment, an insulative coating, such as anodized layer, may be applied to the top surface 134 after the formation of the non-planar surface to improve emissivity. In one embodiment, the insulative coating has a surface finish between about 80 to about 200 micro-inches.

Although the present invention is described in a plasma reactor wherein the substrate is horizontally oriented, it could also apply to a reactor with vertical or inclined substrate orientation.

While the foregoing is directed to embodiments of the present invention, other and further embodiments of the invention may be devised without departing from the basic scope thereof, and the scope thereof is determined by the claims that follow.

The invention is also directed to an apparatus for carrying out the disclosed methods and including apparatus parts for performing each described method steps. These method steps may be performed by way of hardware components, a computer programmed by appropriate software, by any combination of the two or in any other manner. Furthermore, the invention is also directed to methods by which the described apparatus operates. It includes method steps for carrying out every function of the apparatus.

## Claims

1. A substrate support (138) for using in a plasma reactor, comprising:
an electrically conductive body (124) configured to be an electrode of the plasma reactor, wherein the electrically conductive body (124) has a a top surface (134) configured for supporting a substrate and providing heat energy to the substrate, **characterized in that** the top surface has:
a plurality of raised areas (201) connected in a continuous manner to neighboring lowered areas (202), wherein the plurality of raised areas (201) are configured for contacting a back surface of the substrate, the plurality of raised areas (201) occupy less than 50% of the surface area of the top surface (134), and the plurality of raised areas (201) are evenly distributed across the top surface (134); and
an insulative coating covering the top surface (134) of the electrically conductive body (124).

2. The substrate support of claim 1, wherein the plurality of raised areas (201) are connected to the neighboring lowered areas (202) in a continuous manner so that the back surface of the large area substrate is not subjective to damage from scratching.

3. The substrate support of claim 1, wherein the plurality of raised areas (201) have a height relative to the neighboring lowered areas (202) of between 0.0254mm to 0.0508mm.

4. The substrate support of claim 1, wherein the plurality of raised areas (201) are an array of raised islands (203) evenly distributed across the top surface (134).

5. The substrate support of claim 4, wherein the distance between neighboring raised islands (203) is between 0.5mm to 3mm.

6. The substrate support of claim 5, wherein the distance between neighboring raised islands (203) is between 1mm to 2mm.

7. The substrate support of claim 4, wherein each of the plurality of raised islands (203) has a circular contact area with a diameter of less than 0.5mm.

8. The substrate support of claim 1, further comprising a heating element (132) encapsulated in the electrically conductive body (124).

9. The substrate support of claim 1, wherein the electrically conductive body (124) is fabricated from aluminum.

10. The substrate support of claim 1, further comprising one or more reinforcing elements (116, 166) disposed within the electrically conductive body (124).

11. A method for processing a large area substrate in a plasma chamber (100), comprising:
providing a substrate support (138) having an electrically conductive body (124) and an insulative coating covering a top surface (134) of the electrically conductive body (124), wherein the top surface (134) is configured for supporting a substrate and providing heat energy to the substrate, the top surface (134) has a plurality of raised areas (201) connected in a continuous manner to neighboring lowered areas (202), the plurality of raised areas (201) are configured for contacting a back surface of the substrate and the plurality of raised areas (201) occupy less than 50% of the surface area of the top surface and are evenly distributed across the top surface (134);
positioning the substrate on the top surface (134) of the substrate support (138):
introducing a precursor gas to the plasma chamber (100); and
generating a plasma of the precursor gas by applying an RF power between the electrically conductive body (124) and an electrode (118) parallel to the electrically conductive body.

12. The method of claim 11, further comprising heating the substrate using a heating element (132) embedded in the electrically conductive body (124).

13. The method of claim 11, wherein providing the substrate support comprises etching the electrically conductive body to generate the top surface (134) having the plurality of raised areas (201) connected to the neighboring lowered areas (202).

14. The method of claim 11, wherein providing the substrate support comprises using one of chemical etching, electropolishing, grinding, texturing and knurling to generate the top surface (134) having the plurality of raised areas (201) connected to the neighboring lowered areas (202).

15. The substrate support of claim 4, wherein the plurality of raised islands (203) are in a closed packed hexagonal arrangement.

## Patentansprüche

1. Ein Substratträger (138) zur Verwendung in einem Plasmareaktor, umfassend:
ein elektrisch leitfähiger Körper (124), der konfiguriert ist, eine Elektrode des Plasmareaktors zu sein, wobei der elektrisch leitfähige Körper (124) eine obere Oberfläche (134) aufweist, die konfiguriert ist, ein Substrat zu tragen und dem Substrat Wärmeenergie zu liefern, **dadurch gekennzeichnet, dass** die obere Oberfläche:
eine Vielzahl von erhöhten Bereichen (201) aufweist, die auf eine kontinuierliche Weise mit benachbarten, abgesenkten Bereichen (202) verbunden sind, wobei die Vielzahl von erhöhten Bereichen (201) konfiguriert ist, eine Rückseite des Substrates zu kontaktieren, wobei die Vielzahl von erhöhten Bereichen (201) weniger als 50% des Oberflächenbereiches der oberen Oberfläche (134) einnimmt, und wobei die Vielzahl der erhöhten Bereiche (201) gleichmäßig über die obere Oberfläche (134) verteilt ist; und
eine isolierende Beschichtung aufweist, die die obere Oberfläche (134) des elektrisch leitfähigen Körpers (124) bedeckt.

2. Der Substratträger nach Anspruch 1, wobei die Vielzahl der erhöhten Bereiche (201) mit den benachbarten abgesenkten Bereichen (202) auf eine kontinuierliche Art verbunden ist, so dass die Rückseite des großflächigen Substrates keinem Schaden durch Kratzen ausgesetzt ist.

3. Der Substratträger nach Anspruch 1, wobei die Vielzahl der erhöhten Bereiche (201) eine Höhe relativ zu den benachbarten abgesenkten Bereichen (202) von zwischen 0.0254mm und 0.0508mm aufweist.

4. Der Substratträger nach Anspruch 1, wobei die Vielzahl der erhöhten Bereiche (201) ein Anordnung von erhöhten Inseln (203) ist, die gleichmäßig über die obere Oberfläche (134) verteilt sind.

5. Der Substratträger nach Anspruch 4, wobei der Abstand zwischen benachbarten, erhöhten Inseln (203) zwischen 0.5mm und 3mm liegt.

6. Der Substratträger nach Anspruch 5, wobei der Abstand zwischen benachbarten, erhöhten Inseln (203) zwischen 1mm und 2mm liegt.

7. Der Substratträger nach Anspruch 4, wobei jede aus der Vielzahl der erhöhten Inseln (203) einen kreisförmigen Kontaktbereich mit einem Durchmesser von weniger als 0.5mm aufweist.

8. Der Substratträger nach Anspruch 1, weiterhin umfassend ein Heizelement (132), das in dem elektrisch leitfähigen Körper (124) eingeschlossen ist.

9. Der Substratträger nach Anspruch 1, wobei der elektrisch leitfähige Körper (124) aus Aluminium hergestellt ist.

10. Der Substratträger nach Anspruch 1, weiterhin umfassend ein oder mehrere verstärkende Elemente (116, 166), die innerhalb des elektrisch leitfähigen Körpers (124) angeordnet sind.

11. Ein Verfahren zum Bearbeiten eines großflächigen Substrates in einer Plasmakammer (100), umfassend:
Bereitstellen eines Substratträgers (138), der einen elektrisch leitfähigen Körper (124) und eine isolierende Beschichtung, die die obere Oberfläche (134) des elektrisch leitfähigen Körpers (124) bedeckt, aufweist, wobei die obere Oberfläche (134) konfiguriert ist, ein Substrat zu tragen und dem Substrat Wärmeenergie zu liefern, wobei die obere Oberfläche (134) eine Vielzahl von erhöhten Bereichen (201) aufweist, die auf eine kontinuierliche Weise mit benachbarten, abgesenkten Bereichen (202) verbunden ist, wobei die Vielzahl von erhöhten Bereichen (201) konfiguriert ist, eine Rückseite des Substrates zu kontaktieren, und wobei die Vielzahl von erhöhten Bereichen (201) weniger als 50% des Oberflächenbereiches der oberen Oberfläche (134) einnimmt und über die obere Oberfläche (134) gleichmäßig verteilt ist;
Positionieren des Substrates auf der oberen Oberfläche (134) des Substratträgers (138);
Einführen eines Precursor-Gases in die Plasmakammer (100); und
Erzeugen eines Plasmas des Precursor-Gases durch Anwenden von RF Energie zwischen dem elektrisch leitfähigen Körper (124) und einer Elektrode (118), die parallel zu dem elektrisch leitfähigen Körper ist.

12. Das Verfahren nach Anspruch 11, weiterhin umfassend Heizen des Substrates unter Verwendung eines Heizelements (132), das in dem elektrisch leitfähigen Körper (124) eingebettet ist.

13. Das Verfahren nach Anspruch 11, wobei Bereitstellen des Substratträgers Ätzen des elektrisch leitfähigen Körpers umfasst, um eine obere Oberfläche (134) zu erzeugen, die die Vielzahl von erhöhten Bereichen (201) aufweist, die mit den benachbarten, abgesenkten Bereichen (202) verbunden sind.

14. Das Verfahren nach Anspruch 11, wobei Bereitstellen des Substratträgers Verwenden eines von chemischem Ätzen, Elektropolieren, Schleifen, Modellieren, und Rändeln umfasst, um die obere Oberfläche (134) zu erzeugen, die die Vielzahl von erhöhten Bereichen (201) aufweist, die mit den benachbarten, abgesenkten Bereichen (202) verbunden sind.

15. Der Substratträger nach Anspruch 4, wobei die Vielzahl der erhöhten Inseln (203) in einer dichtgepackten hexagonalen Anordnung vorliegt.

## Revendications

1. Support pour substrat (138) pour utilisation dans un réacteur à plasma, comprenant :
un corps conducteur de l'électricité (124) configuré pour être une électrode du réacteur à plasma, le corps conducteur de l'électricité (124) ayant une surface supérieure (134) configurée pour supporter un substrat et pour fournir de l'énergie thermique au substrat,
**caractérisé en ce que** la surface supérieure comporte :
une pluralité de zones en saillie (201) connectées, de manière continue, à des zones abaissées voisines (202), les zones en saillie (201) de la pluralité étant configurées pour être en contact avec une surface arrière du substrat, les zones en saillie (201) de la pluralité occupant moins de 50 % de la superficie de la surface supérieure (134) et les zones en saillie (201) de la pluralité étant distribuées régulièrement d'un côté à l'autre de la surface supérieure (134) ; et **en ce que**
un revêtement isolant couvre la surface supérieure (134) du corps conducteur de l'électricité (124).

2. Support pour substrat selon la revendication 1, dans lequel les zones en saillie (201) de la pluralité sont connectées aux zones abaissées voisines (202) de manière continue de telle sorte que la surface arrière du substrat de grande superficie n'est pas exposée à des dommages par rayure.

3. Support pour substrat selon la revendication 1, dans lequel les zones en saillie (201) de la pluralité ont, par rapport aux zones abaissées voisines (202), une hauteur comprise entre 0,0254 mm et 0,508 mm.

4. Support pour substrat selon la revendication 1, dans lequel les zones en saillie (201) de la pluralité constituent un ensemble d'îlots en saillie (203) distribués régulièrement sur toute la surface supérieure (134).

5. Support pour substrat selon la revendication 4, dans lequel la distance entre îlots en saillie (203) voisins est comprise entre 0,5 mm et 3 mm.

6. Support pour substrat selon la revendication 5, dans lequel la distance entre îlots en saillie (203) voisins est comprise entre 1 mm et 2 mm.

7. Support pour substrat selon la revendication 4, dans lequel chacun des îlots en saillie (203) de la pluralité a une zone de contact circulaire d'un diamètre inférieur à 0,5 mm.

8. Support pour substrat selon la revendication 1, comprenant, en outre, un élément de chauffage (132) encapsulé dans le corps conducteur de l'électricité (124).

9. Support pour substrat selon la revendication 1, dans lequel le corps conducteur de l'électricité (124) est fabriqué en aluminium.

10. Support pour substrat selon la revendication 1, comprenant, en outre, un ou plusieurs éléments de renforcement (16,166) disposés au sein du corps conducteur de l'électricité (124).

11. Procédé de traitement d'un substrat de grande superficie dans une chambre à plasma (100), comprenant :
la fourniture d'un support pour substrat (138) comprenant un corps conducteur de l'électricité (124) et un revêtement isolant couvrant une surface supérieure (134) du corps conducteur de l'électricité (124), la surface supérieure (134) étant configurée pour supporter un substrat et pour fournir de l'énergie thermique au substrat, la surface supérieure (134) ayant une pluralité de zones en saillie (201) connectées, de manière continue, à des zones abaissées voisines (202), les zones en saillie (201) de la pluralité étant configurées pour venir en contact avec une surface arrière du substrat et les zones en saillie (201) de la pluralité occupant moins de 50 % de la superficie de la surface supérieure et étant distribuées régulièrement sur toute la surface supérieure (134) ;
le positionnement du substrat sur la surface supérieure (134) du support pour substrat (138) ;
l'introduction d'un gaz précurseur dans la chambre à plasma (100) ; et
la génération d'un plasma du gaz précurseur par application d'une puissance RF entre le corps conducteur de l'électricité (124) et une électrode (118) parallèle au corps conducteur de l'électricité (124).

12. Procédé selon la revendication 11, comprenant, en outre, le chauffage du substrat en utilisant un élément de chauffage (132) noyé dans le corps conducteur de l'électricité.

13. Procédé selon la revendication 11, dans lequel la fourniture du support pour substrat comprend l'attaque du corps conducteur de l'électricité pour générer la surface supérieure (134) présentant la pluralité de zones en saillie (201) connectées aux zones abaissées voisines (202).

14. Procédé selon la revendication 11, dans lequel la fourniture du support pour substrat comprend l'utilisation de l'une des techniques parmi les suivantes : l'attaque chimique, l'électropolissage, l'abrasion, la texturation et le moletage pour générer la surface supérieure (134) ayant la pluralité de zones en saillie (201) connectées aux zones abaissées voisines (202).

15. Support pour substrat selon la revendication 4, dans lequel les îlots en saillie (203) de la pluralité ont une disposition hexagonale étroitement serrée.
